# FASCICULE DE BREVET EUROPEEN

(11) **EP 0 762 628 B1**
(45) Date de publication et mention de la délivrance du brevet: **25.09.2002**
(21) Numéro de dépôt: 96401846.9
(22) Date de dépôt: 29.08.1996
(51) Int. Cl.: H03D 3/04, H04L 27/156

(54) **Démodulateur de fréquence numérique**
Digitaler Frequenzdemodulator
Digital frequency demodulator

(30) Priorité: 30.08.1995 FR 9510198
(43) Date de publication de la demande: 12.03.1997
(73) Titulaire: Snecma Moteurs, 75015 Paris (FR)
(72) Inventeur: Guiffant, Yves Robert Pierre Jean, 92260 Fontenay aux Roses (FR); Vanoli, Joel Marc, 95120 Ermont (FR)
(74) Mandataire: Berrou, Paul

(56) Documents cités:
- EP-A- 0 175 947
- DE-A- 2 928 976
- US-A- 3 876 945
- US-A- 4 551 846
- US-A- 4 574 247

## Description

La présente invention concerne un démodulateur de fréquence numérique. L'invention s'applique à la démodulation de signaux modulés en fréquence tels que par exemple des signaux de mesure de vitesse, de proximité ou de déplacement délivrés par des capteurs à courants de Foucault.

La démodulation d'un signal modulé en fréquence est généralement effectuée au moyen d'un discriminateur de fréquence constitué d'un circuit fermé appelé boucle de phase comportant un comparateur de phase, un filtre, un amplificateur et un oscillateur à fréquence variable (VCO). Le signal modulé en fréquence et le signal délivré par l'oscillateur sont appliqués en entrée du comparateur de phase qui délivre en sortie un signal proportionnel à la différence de phase entre les fréquences des deux signaux d'entrée. Après filtrage et amplification, le signal délivré par le comparateur est utilisé pour commander l'oscillateur à fréquence variable de manière à asservir la fréquence de l'oscillateur sur la fréquence du signal modulé en fréquence. Cependant les circuits de démodulation mettant en oeuvre une boucle d'asservissement sont des dispositifs analogiques difficiles à mettre au point et présentent des risques d'instabilité. La fréquence initiale de l'oscillateur VCO ne doit pas être trop éloignée de la fréquence du signal à démoduler pour que l'accrochage de la boucle d'asservissement se produise.

Le document EP-A-0 734 138 décrit un démodulateur de fréquence qui fonctionne en fréquencemètre. Ce fonctionnement consiste à compter, par exemple, le nombre de fronts montants ou le nombre de passages par zéro du signal modulé en fréquence. Pour cela, on utilise une horloge de référence de période plus élevée que la période du signal modulé.

La période de mesure obtenue par cette méthode est faible. Cette méthode convient donc bien aux signaux modulés par un signal à haute fréquence , de l'ordre du MHz par exemple, mais ne permet pas de mesurer précisément et dans un temps raisonnable, un signal modulé à très basse fréquence, de l'ordre de quelques Hz, en particulier lorsque la porteuse varie au cours du temps.

L'objet de l'invention est de réaliser un démodulateur de fréquence ne présentant pas les inconvénients des dispositifs de démodulation connus.

Un autre objet de l'invention est de réaliser un démodulateur de fréquence entièrement numérique, présentant une bonne précision, une haute stabilité, un faible coût et un faible encombrement.

Pour cela, l'invention consiste à mesurer les valeurs instantanée et moyenne de la période du signal modulé en fréquence, à comparer les valeurs mesurées et à délivrer un signal binaire qui change d'état à chaque fois que le résultat de la comparaison change de sens. La mesure de la valeur instantanée du signal modulé en fréquence est effectuée par comptage du nombre de périodes d'une horloge de référence contenues dans une période du signal modulé en fréquence.

La mesure de la valeur moyenne du signal modulé en fréquence est effectuée par comptage du nombre de périodes d'une horloge de fréquence N fois plus faible que l'horloge de référence -contenues dans N périodes du signal modulé en fréquence. Le signal binaire obtenu change donc d'état logique au rythme des variations de la période instantanée du signal modulé en fréquence et a la même fréquence que le signal de modulation.

Selon l'invention, le démodulateur de fréquence numérique est caractérisé en ce qu'il comporte :
- un premier compteur pour mesurer la valeur instantanée de la période du signal modulé en fréquence,
- un deuxième compteur pour mesurer la valeur moyenne de la période du signal modulé en fréquence,
- des moyens de comparaison des valeurs instantanée et moyenne mesurées et de reconstitution de la fréquence du signal de modulation.

D'autres particularités et avantages de l'invention apparaitront clairement dans la suite de la description donnée à titre d'exemple non limitatif et faite en regard des figures annexées qui représentent :
- la figure 1, un schéma synoptique du démodulateur de fréquence, selon l'invention ;
- la figure 2, un exemple de chronogrammes illustrant schématiquement pour un signal d'horloge et un signal modulé en fréquence particuliers, l'évolution de différents signaux obtenus en sortie des moyens de mesure et des moyens de comparaison, selon l'invention.

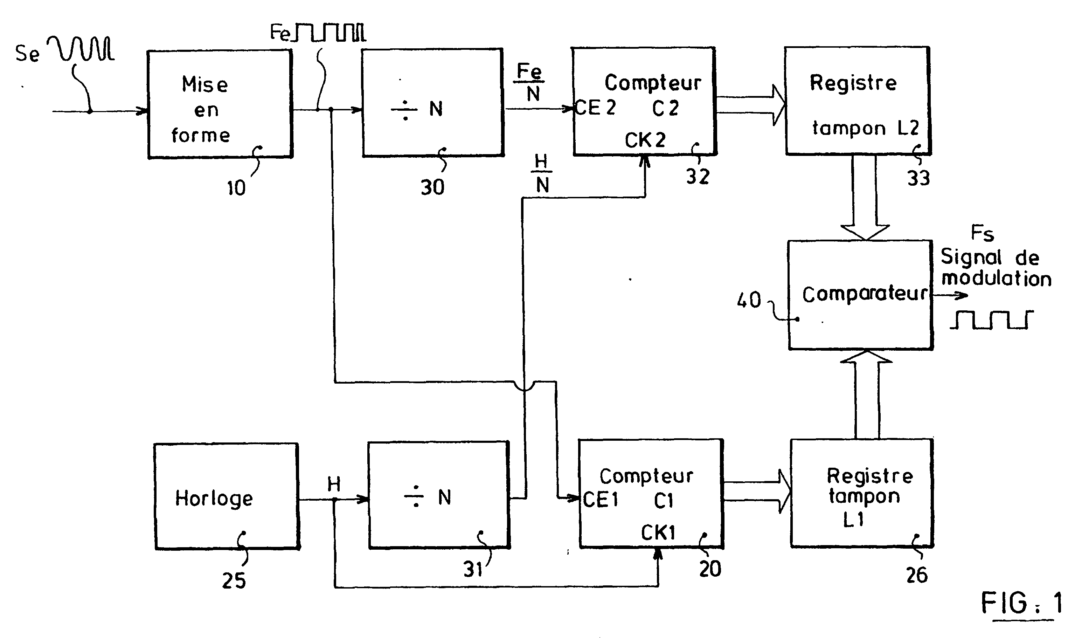

La figure 1 représente un schéma synoptique du démodulateur de fréquence, selon l'invention.

Le démodulateur comporte des moyens 10 de mise en forme d'un signal modulé en fréquence, des moyens de mesure de la valeur instantanée de la période du signal modulé en fréquence, des moyens de mesure de la valeur moyenne de la période du signal modulé en fréquence, des moyens de comparaison des valeurs instantanée et moyenne de la période du signal modulé en fréquence et de reconstitution de la fréquence du signal de modulation.

Les moyens 10 de mise en forme sont destinés à tranformer un signal analogique Se modulé en fréquence en un signal logique Fe.

Les moyens de mesure de la valeur instantanée de la période du signal modulé en fréquence comportent un compteur C1, 20, ayant une entrée de validation CE1 sur laquelle est appliquée le signal logique Fe et une entrée d'horloge CK1 activée par un signal d'horloge H provenant d'une horloge de référence 25. L'horloge 25 est choisie de façon que sa fréquence soit très supérieure à la fréquence du signal Fe, et de façon à présenter une très haute stabilité dans le temps.

Le compteur 20 est destiné à effectuer des cycles de comptage successifs, la durée de chaque cycle correspondant à une période Te du signal modulé en fréquence. A chaque cycle de comptage le compteur 20 compte le nombre d'impulsions p du signal d'horloge H contenu dans une période Te du signal logique Fe. Ce nombre d'impulsions p correspond à la valeur instantanée de la période Te du signal logique Fe rapportée à la période du signal H délivré par l'horloge de-référence 25.

Le comptage peut être effectué indifféremment entre deux fronts montants, deux fronts descendants, ou toute autre combinaison du signal logique Fe ; il peut être effectué de façon synchrone ou asynchrone. A la fin de la période de comptage, le contenu p du compteur 20 est transféré dans un registre tampon L1, 26 (en anglais Latch) par un dispositif logique de contrôle additionnel non représenté, puis remis à zéro. Un nouveau cycle de comptage est alors effectué pour la période suivante du signal Fe.

Les moyens de mesure de la valeur moyenne de la période du signal modulé en fréquence comportent deux diviseurs par N, 30, 31, en entrée desquels sont respectivement appliqués le signal logique Fe et le signal d'horloge H. La valeur de N est un nombre entier éventuellement programmable. Les signaux Fe/N et H/N délivrés respectivement en sortie des diviseurs par N, 30, 31, sont appliqués respectivement sur une entrée de validation CE2 et sur une entrée d'horloge CK2 d'un compteur C2, 32. Le compteur 32 compte le nombre d'impulsions q du signal d'horloge H/N contenu dans N périodes Te du signal logique Fe. Si la valeur N est suffisamment élevée, le nombre q représente la valeur moyenne de la période Te rapportée à la période du signal H délivré par l'horloge de référence 25. Le comptage peut être effectué indifféremment entre (N+1) fronts montants, (N+1) fronts descendants, ou toute autre combinaison du signal Fe/N; il peut être effectué de façon synchrone ou asynchrone.

A la fin des N périodes de comptage, le contenu q du compteur 32 est tranféré dans un registre tampon 33 par le dispositif logique de contrôle additionnel non représenté, puis remis à zéro. Un nouveau cycle de comptage est alors effectué sur les N périodes suivantes du signal Fe.

Les mesures des valeurs instantanées et moyennes de la période Te du signal logique Fe sont effectuées simultanément et en parallèle. Les contenus p et q des registres tampon 26, 33 sont comparés en permanence par un comparateur 40 éventuellement pourvu d'un hystérésis. Le comparateur délivre un signal binaire de sortie FS à deux états logiques 0 ou 1, le signal binaire changeant d'état logique à chaque fois que le résultat de la comparaison change de sens. Ainsi, par exemple, lorsque la valeur instantanée est supérieure à la valeur moyenne de la période Te, la valeur de sortie du comparateur est dans un état logique prédéterminé O ou 1. Lorsque la valeur instantanée devient inférieure à la valeur moyenne, la sortie du comparateur change d'état logique.

Le signal FS change donc d'état logique au rythme des variations de la période instantanée Te, et reconstitue la fréquence du signal de modulation.

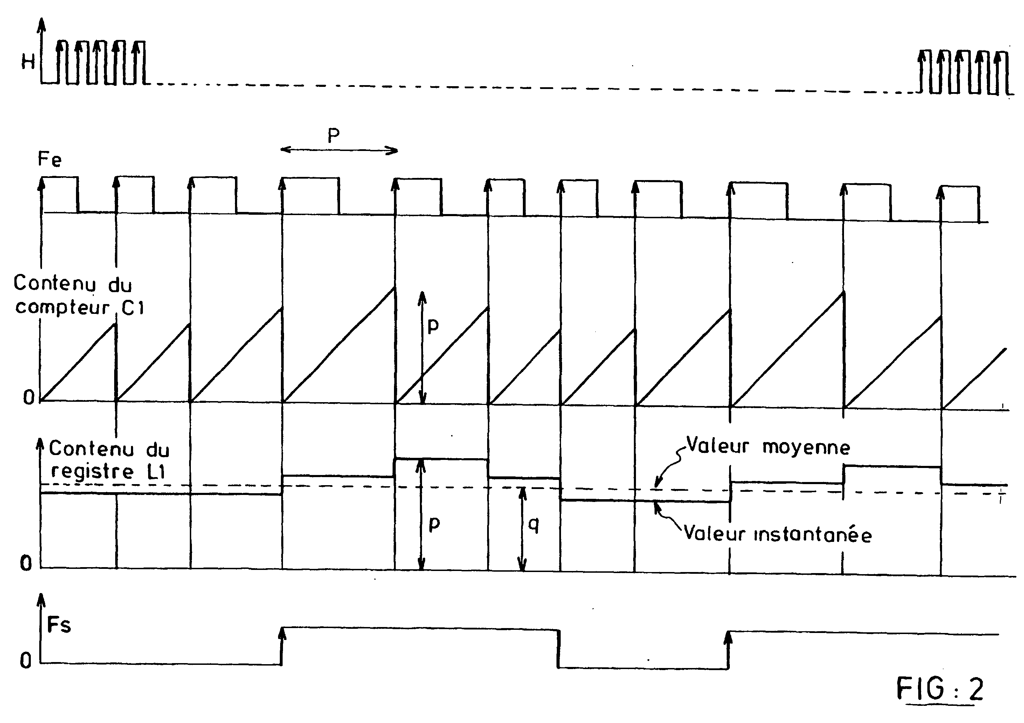

La figure 2 représente un exemple de chronogrammes illustrant schématiquement pour un signal d'horloge H et un signal logique Fe particuliers, l'évolution des contenus du compteur C1, 20 et du registre tampon L1, 26 pendant une dizaine de périodes du signal Fe, ainsi que le signal de sortie du comparateur. Cette figure montre que les variations du contenu du registre L1 reproduisent les variations de la période Te du signal logique Fe et sont représentatives des valeurs instantanées de la période Te.

En superposition avec le contenu du registre L1, est également représentée schématiquement, en pointillés, la valeur moyenne de la période Te, cette valeur moyenne étant mesurée par le compteur C2, 32. Le dernier chronogramme représente le signal logique FS de sortie du comparateur 40. Sur ce chronogramme, la sortie du comparateur est dans l'état logique 0, respectivement 1, lorsque la valeur instantanée est inférieure, respectivement supérieure, à la valeur moyenne de la période Te.

Le démodulateur de fréquence numérique décrit ci-dessus présente les avantages suivants. Son fonctionnement étant basé sur un principe de comptage, il présente un effet intégrateur qui garantit une bonne immunité au bruit.

La possibilité de programmer la valeur N des diviseurs permet de choisir le meilleur compromis entre la -précision et le temps de réponse souhaités pour une application donnée.

Le démodulateur est entièrement numérique, donc exempt de toute dérive et ne nécessite aucun ajustage. Il peut être aisément intégré en un seul composant monolithique de faible coût, directement interfaçable avec un bus microprocesseur.

Sa structure en boucle ouverte et l'absence de discriminateur de fréquence permettent d'éviter les problèmes inhérents aux démodulateurs qui comportent des boucles de phase, et en particulier les problèmes de stabilité et de limitation des plages de fréquence admissibles.

Ce démodulateur est particulièrement bien adapté au traitement des signaux pour lesquels la dérive de la porteuse ( par exemple en température ) est très supérieure au taux de modulation du signal utile.

## Revendications

1. Démodulateur de fréquence numérique **caractérisé en ce qu'**il comporte :
- un premier compteur (20) pour mesurer la valeur instantanée de la période du signal modulé en fréquence, la mesure étant réalisée en effectuant des cycles de comptage successifs, chaque cycle de comptage consistant à compter le nombre d'impulsions du signal d'horloge délivré par une horloge de référence (25) et contenu dans une période du signal modulé en fréquence.
- un deuxième compteur (32) pour mesurer la valeur moyenne de la période du signal modulé en fréquence, la mesure étant réalisée en comptant le nombre d'impulsions d'un signal d'horloge de fréquence N fois plus faible que l'horloge de référence (25) contenues dans N périodes du signal modulé en fréquence.
- des moyens de comparaison (40) des valeurs instantanée et moyenne mesurées et de reconstitution de la fréquence du signal de modulation.

2. Démodulateur de fréquence numérique selon la revendication 1, **caractérisé en ce que** le signal modulé en fréquence est un signal analogique et **en ce qu'**il comporte en outre des moyens (10) de conversion du signal analogique en un signal logique.

3. Démodulateur de fréquence numérique selon la revendication 1 ou 2, **caractérisé en ce que** le premier compteur (20) comporte une entrée de validation sur laquelle est appliqué le signal modulé en fréquence et une entrée d'horloge activée par un signal d'horloge provenant de l'horloge de référence (25), la fréquence du signal d'horloge étant très supérieure à la fréquence du signal modulé.

4. Démodulateur de fréquence numérique selon l'une quelconque des revendications précédentes, **caractérisé en ce qu'**il comporte en outre un registre tampon (26) connecté en sortie du premier compteur (20) et destiné à recevoir à la fin de chaque cycle de comptage, le contenu du premier compteur (20).

5. Démodulateur de fréquence numérique selon l'une quelconque des revendications précédentes **caractérisé en ce que**
- le deuxième compteur (32) comporte une entrée de validation et une entrée d'horloge sur lesquelles sont respectivement appliqués les signaux délivrés par deux diviseurs (30, 31) par un nombre entier N, les deux diviseurs (30,31) recevant respectivement sur leur entrée le signal modulé en fréquence et le signal d'horloge provenant de l'horloge de référence (25)

6. Démodulateur de fréquence numérique selon la revendication 5, **caractérisé en ce qu'**il comporte en outre un registre tampon (33) connecté en sortie du deuxième compteur (32) et destiné à recevoir, à la fin des N périodes de comptage, le contenu du deuxième compteur (32).

7. Démodulateur de fréquence numérique selon l'une quelconque des revendications précédentes, **caractérisé en ce que** les mesures des valeurs instantanées et moyennes de la période du signal modulé en fréquence sont effectuées simultanément et en parallèle.

8. Démodulateur de fréquence numérique selon la revendication 7, **caractérisé en ce que** les contenus des registres tampon (26, 33) sont comparés en permanence par les moyens de comparaison (40).

9. Démodulateur de fréquence numérique selon la revendication 8, **caractérisé en ce que** les moyens de comparaison (40) sont destinés à délivrer un signal binaire à deux états logiques 0 ou 1, ce signal binaire changeant d'état logique à chaque fois que le résultat de la comparaison change de sens.

## Patentansprüche

1. Digitaler Frequenzdemodulator,
**dadurch gekennzeichnet,**
**dass** er aufweist:
- einen ersten Zähler (20) zum Messen des Momentanwerts der Periode des frequenzmodulierten Signals, wobei diese Messung erfolgt, indem aufeinander folgende Zähl-Zyklen durchgeführt werden, wobei jeder Zähl-Zyklus darin besteht, die Anzahl der Impulse des Taktsignals zu zählen, die von einem Referenztaktgeber (25) abgegeben wird und in einer Periode des frequenzmodulierten Signals enthalten ist;
- einen zweiten Zähler (32) zum Messen des Durchschnittswerts der Periode des frequenzmodulierten Signals, wobei diese Messung durch Zählen der Anzahl der Impulse eines Taktsignals mit einer N-fach niedrigeren Frequenz als die des Referenztaktgeber (25) erfolgt, die in N Perioden des frequenzmodulierten Signals enthalten sind;
- Mittel zum Vergleichen (40) des gemessenen Momentanwerts und des Durchschnittswerts und zur Wiederherstellung der Frequenz des Modulationssignals.

2. Digitaler Frequenzdemodulator nach Anspruch 1,
**dadurch gekennzeichnet,**
**dass** das frequenzmodulierte Signal ein analoges Signal ist und dass er ferner Mittel (10) zur Umwandlung des analogen Signals in ein logisches Signal aufweist.

3. Digitaler Frequenzdemodulator nach Anspruch 1 oder 2,
**dadurch gekennzeichnet,**
**dass** der erste Zähler (20) einen Freigabe-Eingang aufweist, an dem das frequenzmodulierte Signal angelegt wird, sowie einen Taktgebereingang aufweist, der durch ein Taktsignal aktiviert wird, das von dem Referenztaktgeber (25) stammt, wobei die Frequenz des Taktsignals sehr viel höher ist als die Frequenz des modulierten Signals.

4. Digitaler Frequenzdemodulator nach einem der vorherigen Ansprüche,
**dadurch gekennzeichnet,**
**dass** er ferner einen Pufferspeicher (26) aufweist, der an den Ausgang des ersten Zählers (20) angeschlossen ist und dazu vorgesehen ist, am Ende jedes Zähl-Zyklus den Inhalt des ersten Zählers (20) aufzunehmen.

5. Digitaler Frequenzdemodulator nach einem der vorherigen Ansprüche,
**dadurch gekennzeichnet, dass**
- der zweite Zähler (32) einen Freigabe-Eingang und einen Taktgebereingang aufweist, an denen entsprechend die Signale angelegt werden, die von zwei Teilern (30, 31) durch eine ganze Zahl N abgegeben werden, wobei die beiden Teiler (30, 31) an ihrem jeweillgen Eingang das frequenzmodulierte Signal bzw. das von dem Referenztaktgeber (25) stammende Taktsignal empfangen.

6. Digitaler Frequenzdemodulator nach Anspruch 5,
**dadurch gekennzeichnet,**
**dass** er ferner einen Pufferspeicher (33) aufweist, der an den Ausgang des zweiten Zählers (32) angeschlossen ist und dazu vorgesehen ist, am Ende der N Zähl-Perioden den Inhalt des zweiten Zählers (32) aufzunehmen.

7. Digitaler Frequenzdemodulator nach einem der vorherigen Ansprüche,
**dadurch gekennzeichnet,**
**dass** die Messungen der Momentanwerte und Durchschnittswerte der Periode des frequenzmodulierten Signals gleichzeitig und parallel erfolgen.

8. Digitaler Frequenzdemodulator nach Anspruch 7,
**dadurch gekennzeichnet,**
**dass** die Inhalte der Pufferspeicher (26, 33) permanent durch die Mittel zum Vergleichen (40) verglichen werden.

9. Digitaler Frequenzdemodulator nach Anspruch 8,
**dadurch gekennzeichnet,**
**dass** die Mittel zum Vergleichen (40) dazu vorgesehen sind, ein binäres Signal mit zwei logischen Zuständen 0 oder 1 abzugeben, wobei dieses binäre Signal jedes Mal, wenn das Ergebnis des Vergleichs das Vorzeichen ändert, seinen logischen Zustand ändert.

## Claims

1. Digital frequency demodulator **characterized in that** it comprises:
- a first counter (20) for measuring the instantaneous value of the period of the frequency-modulated signal, the measurement being carried out by performing successive counting cycles, each counting cycle consisting in counting the number of pulses of the clock signal delivered by a reference clock (25) and contained in a period of the frequency-modulated signal,
- a second counter (32) for measuring the mean value of the period of the frequency-modulated signal, the measurement being carried out by counting the number of pulses of a clock signal of frequency N times lower than the reference clock (25) which are contained in N periods of the frequency-modulated signal
- means of comparison (40) of the measured instantaneous and mean values and of reconstruction of the frequency of the modulation signal.

2. Digital frequency demodulator according to Claim 1, **characterized in that** the frequency-modulated signal is an analogue signal and **in that** it furthermore comprises means (10) for converting the analogue signal into a logic signal.

3. Digital frequency demodulator according to Claim 1 or 2, **characterized in that** the first counter (20) comprises an enabling input to which is applied the frequency-modulated signal and a clock input activated by a clock signal originating from the reference clock (25), the frequency of the clock signal being much greater than the frequency of the modulated signal.

4. Digital frequency demodulator according to any one of the preceding claims, **characterized in that** it furthermore comprises a buffer register (26) connected at the output of the first counter (20) and intended to receive at the end of each counting cycle, the content of the first counter (20).

5. Digital frequency demodulator according to any one of the preceding claims, **characterized in that**
- the second counter (32) comprises an enabling input and a clock input to which are respectively applied the signals delivered by two dividers (30, 31) by an integer number N, the two dividers (30, 31) respectively receiving on their input the frequency-modulated signal and the clock signal originating from the reference clock (25).

6. Digital frequency demodulator according to Claim 5, **characterized in that** it furthermore comprises a buffer register (33) connected at the output of the second counter (32) and intended to receive, at the end of the N counting periods, the content of the second counter (32).

7. Digital frequency demodulator according to any one of the preceding claims, **characterized in that** the measurements of the instantaneous and mean values of the period of the frequency-modulated signal are performed simultaneously and in parallel.

8. Digital frequency demodulator according to Claim 7, **characterized in that** the contents of the buffer registers (26, 33) are compared continuously by the means of comparison (40).

9. Digital frequency demodulator according to Claim 8, **characterized in that** the means of comparison (40) are intended for delivering a binary signal with two logic states 0 or 1, this binary signal changing logic state each time the result of the comparison changes direction.
